# EUROPÄISCHE PATENTSCHRIFT

(11) **EP 2 813 856 B1**
(45) Veröffentlichungstag und Bekanntmachung des Hinweises auf die Patenterteilung: **06.01.2016**
(21) Anmeldenummer: 14170770.3
(22) Anmeldetag: 02.06.2014
(51) Int. Cl.: G01R 15/18, G01R 19/00

(54) **Integrierte Schaltung mit digitalem Verfahren zur alltromsensitiven Differenzstrommessung**
Integrated circuit with digital method for differential current measurement sensitive to universal sensitive currents
Circuit intégré avec procédé numérique de mesure du courant différentiel sensible à tous les courants

(30) Priorität: 10.06.2013 DE 102013210800
(43) Veröffentlichungstag der Anmeldung: 17.12.2014
(73) Patentinhaber: Bender GmbH & Co. KG, 35305 Grünberg (DE)
(72) Erfinder: Hackl, Dieter, 35463 Fernwald (DE); Kammer, Michael, 35410 Hungen (DE)
(74) Vertreter: advotec.

(56) Entgegenhaltungen:
- EP-A2- 2 384 922
- AT-A4- 507 202
- DE-A1- 19 826 410

## Beschreibung

Die Erfindung betrifft ein Verfahren und eine Vorrichtung zur galvanisch getrennten, allstromsensitiven Messung eines Differenzstromes, mit einer Oszillatorschaltung, die ein magnetfeldempfindliches Bauelement aufweist, das im Verlauf der Oszillation zwischen mindestens zwei Zuständen wechselt, wobei durch den Differenzstrom ein Magnetfeld im Wirkungsbereich des magnetfeldempfindlichen Bauelementes ausgebildet wird und die Oszillatorschaltung ein Oszillatorsignal erzeugt, das zwischen einem Zustand 1 und einem Zustand 2 kippt.

Bekannt sind Messverfahren und Messvorrichtungen zur Überwachung elektrischer Anlagen wie beispielsweise Differenzstrom-Überwachungsgeräte (RCMs) oder Fehlerstrom-Schutzeinrichtungen (RCDs). Diese bekannten Verfahren und Vorrichtungen beruhen überwiegend auf dem Prinzip der galvanisch getrennten Differenzstrommessung, bei dem alle aktiven Leiter einer zu überwachenden elektrischen Leitung als Primärwicklung durch einen Messstromwandler mit Stromwandlerkern aus ferromagnetischem Material und mit mindestens einer Sekundärwicklung geführt werden. Im fehlerfreien Betrieb der elektrischen Anlage ist die vektorielle Summe der Ströme auf allen stromführenden Leitern der Leitung gleich Null und somit existiert auch kein Magnetfeld in der Umgebung dieser Leitung. Entsteht beispielsweise auf Grund eines Isolationsfehlers in der elektrischen Anlage ein Fehlerstrom, der außerhalb der Leitung über einen Körper bzw. über Erde abfließt, ergibt sich ein Differenzstrom. Das veränderliche Magnetfeld dieses Differenzstroms induziert sekundärseitig einen Strom, der ausgewertet werden kann und gegebenenfalls eine Meldung veranlasst (RCM) oder ein Schaltglied auslöst (RCD), das die fehlerbehaftete Leitung trennt.

In einfachster Variante sind derartige Einrichtungen auf Grund des Induktionsprinzips nur in der Lage, zeitliche Änderungen des magnetischen Flusses und damit in der Praxis nur reine Wechselfehlerströme bzw. Wechseldifferenzströme zu detektieren. An die elektrische Anlage angeschlossene Verbraucher wie beispielsweise elektrische Maschinen, die elektronische Halbleiterbauelemente wie Dioden oder Thyristoren in Gleichrichtern oder Frequenzumrichtern aufweisen, können allerdings auch Differenzströme erzeugen, die einen nicht rein sinusförmigen, sondern einen pulsierenden zeitlichen Verlauf besitzen oder einen reinen Gleich(-Differenz)-Strom bilden. Um auch diese Differenzstromarten erfassen zu können, sind Methoden zur allstromsensitiven Differenzstrommessung entwickelt worden.

Unter diesen Entwicklungen sind Verfahren und Vorrichtungen bekannt, bei denen der Messstromwandler als schwingungserzeugendes Element in einen Gegentaktoszillator integriert ist und Gleichstrommagnetisierungen durch einen sekundär eingeprägten Oszillatorstrom kompensiert werden.

Bekannt ist auch ein Verfahren, bei dem ein Stromwandlerkern mit einer nichtlinearen Magnetisierungskurve als magnetfeldempfindliches Bauelement Bestandteil einer als Relaxationsschwinger-Schaltung (Kippschwinger) ausgeführten Oszillatorschaltung ist. Die Relaxationsschwinger-Schaltung bewirkt, dass die nichtlineare Magnetisierungskurve infolge eines gesteuerten sekundärseitigen Stromflusses zwischen der positiven und negativen Sättigung oszillierend durchfahren wird, wobei der Stromwandlerkern im Verlauf der Oszillation zwischen zwei gut unterscheidbaren magnetischen Zuständen wechselt. Aus dem zeitlichen Verlauf der (Oszillator-)Sekundärströme kann ein zeitmoduliertes Oszillatorsignal abgeleitet werden, das zwischen einem Zustand 1 und einem Zustand 2 kippt und wobei sich die Dauer der jeweiligen Signalabschnitte in Zustand 1 und 2 (Verweilzeiten) in Abhängigkeit des Differenzstroms einstellt. Durch eine geeignete Demodulation in einer Auswerteschaltung, beispielsweise durch Mittelwertbildung mittels einer analogen Tiefpassfilterung, wird der differenzstromproportionale Gleichanteil ermittelt.

Als nachteilig bei den bekannten Verfahren zur allstromsensitiven Differenzstrommessung erweist sich, dass unvermeidbare herstellungsbedingte Toleranzen bei den Bauelementen der Oszillatorschaltung und der Auswerteschaltung zu Fehlmessungen führen und die Zuverlässigkeit der Messung gefährden. Insbesondere eine Demodulation durch analoge Tiefpassfilterung stellt an die Qualität der verwendeten Bauelemente hohe Anforderungen, die oftmals nur durch Kosten verursachende paarweise Selektion der Bauteile erfüllt werden können. Um präzise Messergebnisse zu erzielen setzen die bekannten Verfahren zudem die Einhaltung eng spezifizierter Parametervorgaben für das magnetfeldempfindliche Bauelement voraus. Darüber hinaus ist der Dynamikbereich durch die Auswahl der Bauelemente fest vorgegeben, so dass der Einsatzbereich oftmals eingeschränkt ist.

Der vorliegenden Erfindung liegt somit die Aufgabe zu Grunde, ein Verfahren und eine Vorrichtung zur galvanisch getrennten, allstromsensitiven Messung eines Differenzstromes zu entwickeln, die eine zuverlässige Messung in breiten Einsatzbereichen bei geringen Herstellungskosten der Vorrichtung ermöglichen.

Diese Aufgabe wird mit Bezug auf ein Verfahren in Verbindung mit dem Oberbegriff des Anspruchs 1 dadurch gelöst, dass in Abhängigkeit des differenzstromgetriebenen Magnetfeldes sich in den Zuständen 1 und 2 einstellende Verweilzeiten des Oszillatorsignals bestimmt werden und aus dem Verhältnis dieser Verweilzeiten ein differenzstromproportionales Ausgangssignal gewonnen wird.

Der Grundgedanke der vorliegenden Erfindung beruht darauf, dass die jeweiligen durch das differenzstromgetriebene Magnetfeld beeinflussten Verweilzeiten in den Zuständen 1 und 2 des zeitmodulierten Oszillatorsignals bestimmt werden und aus dem Verhältnis dieser Verweilzeiten ein differenzstromproportionales Ausgangssignal gewonnen wird.

Die konkrete Umsetzung der Oszillatorschaltung ist dabei für die Anwendbarkeit der Erfindung unerheblich. Entscheidend ist das Vorhandensein eines magnetfeldempfindlichen Bauelements mit der Eigenschaft, im Verlauf der Oszillation zwei eindeutig voneinander unterscheidbare Zustände annehmen zu können. Ein solches magnetfeldempfindliches Bauelement kann als ein den Verlauf des Oszillatorsignals bestimmender Bestandteil derart in eine Relaxationsschwinger-Schaltung integriert werden, dass ein Oszillatorsignal erzeugt wird, welches zwischen den (elektrischen) Zuständen 1 und 2 kippt.

Beispielhaft sei der Verfahrensablauf anhand einer Realisierung der Oszillatorschaltung als Relaxationsschwinger-Schaltung in Kombination mit einem Messstromwandler und zwei induktiv miteinander gekoppelten Sekundärwicklungen erläutert. Dabei wird von einer nichtlinearen Magnetisierungskurve des Stromwandlerkerns ausgegangen, die näherungsweise durch einen abschnittsweise linearen Verlauf mit angrenzenden Sättigungsbereichen dargestellt werden kann. Im Verlauf der Oszillation, d.h. beim Durchfahren der gesamten Magnetisierungskennlinie, nimmt das magnetfeldempfindliche Bauelement - hier der Stromwandlerkern - also zwei gut voneinander unterscheidbare (magnetische) Zustände an: Zum einen ein Zustand im linearen Bereich, zum anderen ein Zustand im Sättigungsbereich.

Die zu überwachende Leitung wirkt als Primärwicklung, wobei sich ein durch die Größe und Art des Differenzstroms vorgegebener Arbeitspunkt auf der Magnetisierungskurve einstellt. Dabei kann der Arbeitspunkt sowohl zeitlich konstant sein (Gleich-Differenzstrom) als auch bei zeitlich veränderlichem Differenzstrom auf der Magnetisierungskurve wandern.

Auf Grund einer auf der induktiven Kopplung beruhenden Mitkopplungsschaltung der Sekundärspulen kippt der Oszillator in den Sättigungspunkten, wobei ein in einem der beiden Sekundärstromkreise stetig zunehmender Strom in einen stetig abnehmenden Strom kippt, während in dem jeweils anderen Sekundärstromkreis ein stetig abnehmender Strom in einen stetig zunehmenden Strom kippt. Es findet somit im Sättigungszustand des Stromwandlerkerns ein Vorzeichenwechsel des differenzierten (zeitlich abgeleiteten) Sekundärstromes statt, wobei die Stromflusszeiten ausgehend von dem durch den Differenzstrom vorgegebenen Arbeitspunkt bis zum Erreichen der Sättigungspunkte in Abhängigkeit der Lage des Arbeitspunktes unterschiedlich sind und zu einer zeitlichen Modulation der auf die jeweiligen differenzierten Sekundärströme angewandten Vorzeichenfunktion führen.

Das Durchfahren der Magnetisierungskennlinie wird also über eine möglichst lineare Funktion in die Verweilzeiten des Oszillatorsignals abgebildet, wobei sich die den durchfahrenen Strecken auf der Magnetisierungskurve entsprechenden Verweilzeiten in Abhängigkeit des Arbeitspunktes ergeben. Befindet sich beispielsweise der Arbeitspunkt infolge eines relativ hohen Differenzstromes nahe dem oberen Sättigungspunkt auf dem linearen Streckenabschnitt der Magnetisierungskurve, so wird im Verlauf der durch die (Oszillator-)Sekundärströme bewirkten Oszillation bis zum Erreichen des oberen Sättigungspunktes eine kürzere Strecke auf dem linearen Abschnitt durchfahren als bei einem kleineren Differenzstrom - es ergibt sich eine kürzere Verweildauer. Das zeitmodulierte Oszillatorsignal weist daher je nach Lage des Arbeitspunktes und damit in Abhängigkeit des Differenzstroms unterschiedlich lange High-/Low-Phasen (Zustand 1/Zustand 2) auf.

Unabhängig von der konkreten Umsetzung der Oszillatorschaltung muss also für die Anwendung der weiteren Verfahrensschritte ein auswertbares elektrisches Signal (Oszillatorsignal) zur Verfügung gestellt werden, in dessen zeitlichem Verlauf die Information über die Zustandsänderungen des magnetfeldempfindlichen Bauelements enthalten ist.

Zur Rückgewinnung dieser Information und damit zur Gewinnung des gewünschten differenzstromproportionalen Ausgangssignals werden erfindungsgemäß die Verweilzeiten des Oszillatorsignals in den Zuständen 1 und 2 bestimmt und miteinander ins Verhältnis gesetzt.

Damit kann unabhängig von einer konkreten Realisierung der Oszillatorschaltung ein sehr universell einsetzbares Verfahren bereitgestellt werden, das eine schnelle und zuverlässige Differenzstrommessung ermöglicht.

In weiterer vorteilhafter Ausgestaltung erfolgt die Bestimmung der Verweilzeiten mit einem aus einer Oszillatorfrequenz abgeleiteten Zähltakt, dessen Taktrate um ein Vielfaches höher ist als die Oszillatorfrequenz.

Mit dem von der Oszillatorfrequenz abgeleiteten Zähltakt werden die Verweilzeiten im Zustand 1 und Zustand 2 gezählt und daraus ein Puls /Periodenverhältnis bestimmt. Dieses Verhältnis ist bei einem weitgehend linearen Zusammenhang im zu betrachtenden Differenzstrommessbereich proportional zu dem Differenzstrom. Die Kopplung des Zähltaktes an die Oszillatorfrequenz führt zu einer geringeren Abhängigkeit des Messergebnisses von Temperatur- oder Langzeitdriften. Eine praktisch immer vorhandene Drift der Oszillatorfrequenz geht nicht in die Messgenauigkeit ein. Zudem führt die um ein Vielfaches höhere Taktrate zu einer höheren Präzision der Messung, verbunden mit einer erhöhten Messdynamik.

Mit Vorteil erfolgen die Erzeugung des Oszillatorsignals sowie die Bestimmung der Verweilzeiten und die Gewinnung des differenzstromproportionalen Ausgangssignals auf digitaler Ebene mit Methoden der digitalen Signalverarbeitung in einem integrierten Schaltkreis.

Diese Form der Ausführung des Verfahrens ermöglicht es, Abhängigkeiten von physikalischen Größen, die innerhalb und außerhalb der Oszillatorschaltung auftreten (z.B. Strom, Spannung und Frequenz des Oszillatorsignals, Kennwerte des magnetfeldempfindlichen Bauelements, Temperatur) zusammenhängend zu erfassen und in die Ermittlung eines zuverlässigen Messergebnisses einzubeziehen. Durch die integrale Betrachtung kann das Verfahren unter Reduktion von Störeinflüssen an die jeweilige Messaufgabe angepasst werden, wobei bei großem Dynamikbereich eine hohe Messgenauigkeit erreicht werden kann.

Digitale Signalverarbeitungsalgorithmen ermöglichen dabei eine Erweiterung des Messdynamikbereichs bei gleichzeitig erhöhter Messgenauigkeit. Verbunden damit ist eine geringere Abhängigkeit von der strengen Einhaltung eng spezifizierte Parameter für externe Bauelemente, insbesondere kann das magnetfeldempfindliche Bauelement größere Toleranzbereiche aufweisen und damit Kosten senkend wirken. Darüber hinaus kann mit diesem digitalen Auswertungsprinzip Störeinflüssen durch Temperatur- und Langzeitdriften wirksam begegnet werden.

Vorteilhaft ist eine Ausgabe des differenzstromproportionalen Ausgangssignals als analoges Signal. Damit ist eine direkte Weiterverarbeitung des Messergebnisses auf analoger Ebenes zu möglich.

Bevorzugt wird das differenzstromproportionale Ausgangssignal auch als digitales Signal über eine digitale Schnittstelle ausgegeben. Zusätzlich zu dem analogen Ausgangssignal wird damit ein digitales differenzstromproportionales Ausgangssignal bereitgestellt, dessen Übertragung über die digitale Schnittstelle nach einem festgelegten Schnittstellenprotokoll erfolgt.

Mit Vorteil ist das Verfahren derart ausgelegt, dass in dem integrierten Schaltkreis analoge und digitale Signale verarbeitet werden können. Diese Auslegung ermöglicht eine hochintegrierte Umsetzung des Verfahrens in einen Schaltkreis ohne kostenaufwändige externe Bauelemente.

Vorteilhafterweise wird die Oszillatorschaltung durch eine Kontroll- und Steuereinheit gesteuert. Die Kontroll- und Steuereinheit ist dabei in der Lage, Parameterwerte zu überprüfen und gegebenenfalls zu korrigieren. Im Falle der Realisierung einer Relaxationsschwinger-Schaltung mit einem Messstromwandler können so beispielsweise die Parameter der Versorgungseinheit für die Sekundärstromkreise optimiert werden.

Bevorzugt beruht die Steuerung der Oszillatorschaltung durch die Kontroll- und Steuereinheit auf einem Modell des verwendeten magnetfeldempfindlichen Bauelementes. Dies führt zu einer Erhöhung der Fehlertoleranz gegenüber Streuungen in der Fertigungsqualität bei der Herstellung von magnetfeldempfindlichen Bauelementen, so dass auch mit einfachen magnetfeldempfindlichen Bauelementen hinreichend gute Messergebnisse erzielt werden können. Darüber hinaus werden die Genauigkeit, die Stabilität sowie die Zuverlässigkeit der Messung verbessert.

Mittels einer Diagnoseeinheit sind ein Test und eine Überwachung der Funktion der Oszillatorschaltung durchführbar. Das Verfahren ist vorteilhafterweise so ausgestaltet, dass seine fehlerfreie Durchführung ständig von der Diagnoseeinheit überwacht wird. Zusammen mit der Möglichkeit, einen Funktionstest durchführen zu können, steht damit ein wirksames Instrumentarium zur Verfügung, um das Verfahren auch in sicherheitskritischen Messaufgaben anzuwenden zu können.

Bevorzugt ist eine Implementierung des Verfahrens als anwendungsspezifischer integrierter Schaltkreis vorgesehen.

Mit Bezug auf eine Vorrichtung zur galvanisch getrennten, allstromsensitiven Messung eines Differenzstromes wird die Aufgabe in Verbindung mit dem Oberbegriff des Anspruchs 11 gelöst durch eine Auswerteschaltung zur Bestimmung von in Abhängigkeit des differenzstromgetriebenen Magnetfeldes sich in den Zuständen 1 und 2 einstellenden Verweilzeiten des Oszillatorsignals und zur Gewinnung des differenzstromproportionalen Ausgangssignals aus dem Verhältnis dieser Verweilzeiten.

Die vorgenannten mit Bezug auf das Verfahren aufgeführten vorteilhaften technischen Wirkungen gelten ebenso für die das Verfahren realisierende Vorrichtung.

In Umsetzung der erfindungsgemäßen Verfahrensschritte weist eine entsprechende Vorrichtung erfindungsgemäß eine Auswerteschaltung auf, die die jeweiligen Verweilzeiten in den Zuständen 1 und 2 des zeitmodulierten Oszillatorsignals bestimmt und aus dem Verhältnis dieser Verweilzeiten ein differenzstromproportionales Ausgangssignal gewinnt.

Die Information über die Größe des zu ermittelnden Differenzstromes liegt in der unterschiedlichen Länge der High-/Low-Phasen des modulierten Oszillatorsignals, also in dem Unterschied der jeweiligen Verweilzeiten im Zustand 1 und Zustand 2. Die Auswerteschaltung bestimmt diese Verweilzeiten und gewinnt aus ihrem Verhältnis zueinander eine Aussage über die Größe des Differenzstroms.

In weiterer vorteilhafter Ausgestaltung umfasst die Auswerteschaltung zur Bestimmung der Verweilzeiten eine Zählschaltung zur Erzeugung eines aus einer Oszillatorfrequenz abgeleiteten Zähltaktes, dessen Taktrate um ein Vielfaches höher ist als die Oszillatorfrequenz.

Die Bestimmung der Verweilzeiten erfolgt somit über einen schnellen Zähltakt. Dieser ist an die Oszillatorfrequenz gekoppelt, so dass vorteilhafterweise eine Drift der Oszillatorfrequenz nicht in die Messgenauigkeit eingeht.

Weiterhin sind die Oszillatorschaltung und die Auswerteschaltung als digitale Schaltungen in einem integrierten Schaltkreis ausgeführt.

Die Integration der Funktionsblöcke und deren Umsetzung in einen integrierten Schaltkreis ermöglicht gegenüber der aus dem Stand der Technik bekannten Realisierung als diskrete elektronische Bauelemente eine erhöhte Zuverlässigkeit der Differenzstrommessung bei gleichzeitig niedrigeren Herstellungskosten der Messvorrichtung, da aufwändige Bauteilselektionen und Abgleicharbeiten entfallen. Die digitale Oszillatorschaltung weist gegenüber einem Aufbau aus diskreten Bauelementen einen erheblich breiteren Einsatzbereich auf, da der integrierte Schaltkreis für die jeweilige Messaufgabe konfigurierbar ist und eine höhere Messgenauigkeit liefert. Die digitale Auswerteschaltung basiert auf einer Kombination von präzisen Komparatoren, schnellen digitalen Zählern mit großem Dynamikbereich, einem schnellen dividierenden Rechenwerk und einer digitalen Mittelwertbildung.

Zudem zeigt sich der integrierte Schaltkreis erheblich unempfindlicher gegenüber äußeren Störeinflüssen, da diese Störfaktoren unter Berücksichtigung weiterer Abhängigkeiten gemeinsam erfasst, ausgewertet und kompensiert werden können.

Weiterhin weist die digitale Auswerteschaltung einen Signalausgang für ein analog umgesetztes differenzstromproportionales Ausgangssignal auf.

Das in der digitalen Auswerteschaltung erzeugte, in digitaler Form vorliegende, differenzstromproportionale Ausgangssignal wird in ein analoges Ausgangssignal umgesetzt und ausgegeben, um die Weiterverarbeitung dieses Messergebnisses auf analoger Ebenes zu ermöglichen.

In Ergänzung des von der digitalen Auswerteschaltung bereitgestellten D/A-umgesetzten analogen Ausgangssignals ist eine digitale Schnittstelle zur Ausgabe eines digitalen differenzstromproportionalen Ausgangssignals vorgesehen

Diese zweikanalige -analoge und digitale -, redundante Form der Bereitstellung des Messergebnisses bietet eine erhöhte Sicherheit bei sicherheitskritischen Anwendungen.

In weiterer vorteilhafter Ausgestaltung weist der integrierte Schaltkreis Schaltungselemente zur Verarbeitung analoger und digitaler Signale auf. Der integrierte Schaltkreis stellt somit eine Oszillatorschaltung in hochintegrierter Form dar, die in der Lage ist, externe Signale in analoger und digitaler Form aufzunehmen und zu verarbeiten. Auf eine kostenaufwändige Montage externer Bauelemente kann weitgehend verzichtet werden, so dass in Verbindung mit einem externen magnetfeldempfindlichen Bauelement eine universell einsetzbare Vorrichtung zur allstromsensitiven Differenzstrommessung bereitgestellt wird.

In vorteilhafter Ausgestaltung weist der integrierte Schaltkreis eine Kontroll- und Steuereinheit zur Steuerung der Oszillatorschaltung auf. Die Kontroll- und Steuereinheit überwacht die Einhaltung vorgegebener und korrigiert diese gegebenenfalls. Sie dient beispielsweise der Überwachung und der Korrektur der zulässigen Strom- und Spannungswerte in der Versorgungseinheit für das externe magnetfeldempfindliche Bauelement und stellt die Einhaltung der Oszillatorfrequenz sicher.

Mit Vorteil weist der integrierte Schaltkreis Speichermittel zur Hinterlegung eines Modells des verwendeten magnetfeldempfindlichen Bauelementes auf. Es wird somit ein Modell des jeweils verwendeten magnetfeldempfindlichen Bauelementes gespeichert, auf das die Kontroll- und Steuereinheit zugreifen kann, um auf der Basis der gespeicherten Daten die Parameter zu überwachen und gegebenenfalls zu korrigieren. Damit ist beispielsweise bei der Verwendung eines Messstromwandlers als magnetfeldempfindliches Bauelement gewährleistet, dass auch bei großen Toleranzen des Magnetkernmaterials der Oszillatorbetrieb zuverlässig und präzise funktioniert. Insbesondere können auch Nachteile ausgeglichen werden, die bei der Verwendung qualitativ wenig hochwertiger magnetfeldempfindlicher Bauelemente entstehen oder es kann allgemein höheren Messanforderungen entsprochen werden.

Vorzugsweise umfasst der integrierte Schaltkreis eine Diagnoseeinheit zum Testen und Überwachen der Funktion der Oszillatorschaltung. Die Integration einer Diagnoseeinheit erhöht die Zuverlässigkeit der Messvorrichtung gegenüber konventionellen Lösungen. Auch in Verbindung mit der zweikanaligen Bereitstellung des Ausgangssignals eignet sich die Messvorrichtung dadurch in besonderer Weise für sicherheitskritische Anwendungen.

In vorzugsweiser Ausgestaltung ist der integrierte Schaltkreis als anwendungsspezifischer integrierter Schaltkreis ausgeführt. Insbesondere bei der Produktion in hoher Stückzahl erweist sich eine Ausführung des integrierten Schaltkreises als anwendungsspezifischer integrierter Schaltkreis (ASIC) im Sinne niedriger Herstellungskosten von Vorteil. Da der integrierte Schaltkreis sowohl analoge als auch digitale Signale verarbeitet, stellt dessen Implementierung ein "mixed signal" ASIC dar.

Weitere vorteilhafte Ausgestaltungsmerkmale ergeben sich aus der nachfolgenden Beschreibung und den Zeichnungen, die eine bevorzugte Ausführungsform der Erfindung beispielhaft erläutern. Dabei ist die Oszillatorschaltung als Relaxationsschwinger-Schaltung in Kombination mit einem Messstromwandler als magnetfeldempfindliches Bauelement ausgeführt.

Es zeigen die
- **Fig. 1:**: ein Prinzipschaltbild einer Relaxationsschwinger-Schaltung,
- **Fig. 2:**: ein Durchfahren einer Magnetisierungskurve,
- **Fig. 3:**: schematisch ein aus der Magnetisierungskurve nach **Fig. 2** abgeleitetes Oszillatorsignal mit nachfolgender Tiefpassfilterung und
- **Fig. 4:**: ein funktionales Blockschaltbild einer Messvorrichtung als integrierter Schaltkreis.

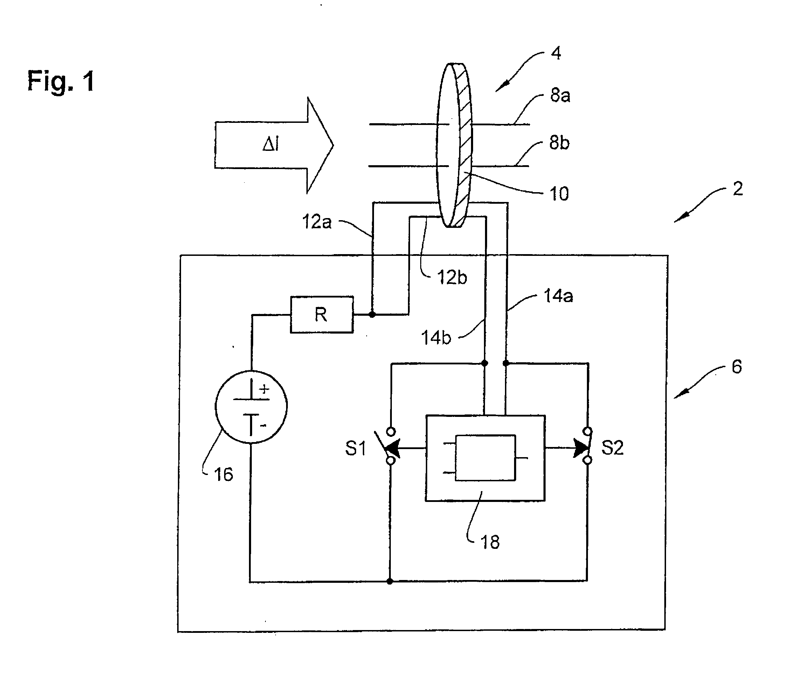

**Fig. 1** zeigt ein Prinzipschaltbild einer Messvorrichtung 2 mit einem Messstromwandler 4 und einer als Relaxationsschwinger-Schaltung 6 ausgeführten Oszillatorschaltung. Zwei aktive Leiter 8a, 8b einer zu überwachenden Leitung sind durch einen ringförmigen Stromwandlerkern 10 des Messstromwandlers 4 geführt. Die aktiven Leiter 8a, 8b bilden eine Primärwicklung, auf der sich im Fehlerfall der elektrischen Anlage ein Differenzstrom ΔI einstellt. Über den Stromwandlerkern 10 sind zwei Sekundärwicklungen 12a, 12b mit gegensinnigem Wicklungssinn induktiv miteinander gekoppelt. Die Sekundärwicklungen 12a, 12b bilden dabei die induktiven Komponenten des Relaxationsoszillator-Schwingkreises, der zwei Sekundärstromkreise 14a, 14b umfasst, wobei jeweils ein Anschluss der beiden Sekundärwicklungen 12a, 12b über einen gemeinsamen strombegrenzenden Vorwiderstand R an eine gemeinsame Spannungsquelle 16 als Versorgungseinheit angeschlossen sind. Die Oszillation der Sekundärströme in den Sekundärstromkreisen 14a, 14b wird von einer Steuerelektronik 18, die eine Mitkopplungsschaltung der beiden Sekundärstromkreise 14a, 14b umfasst, über die komplementär arbeitenden Schaltelemente S1, S2 derart gesteuert, dass die Magnetisierungskurve des Stromwandlerkerns 10 infolge der in den Sekundärstromkreisen 14a, 14b fließenden, von der Spannungsquelle 16 getriebenen, Strömen vollständig durchfahren wird.

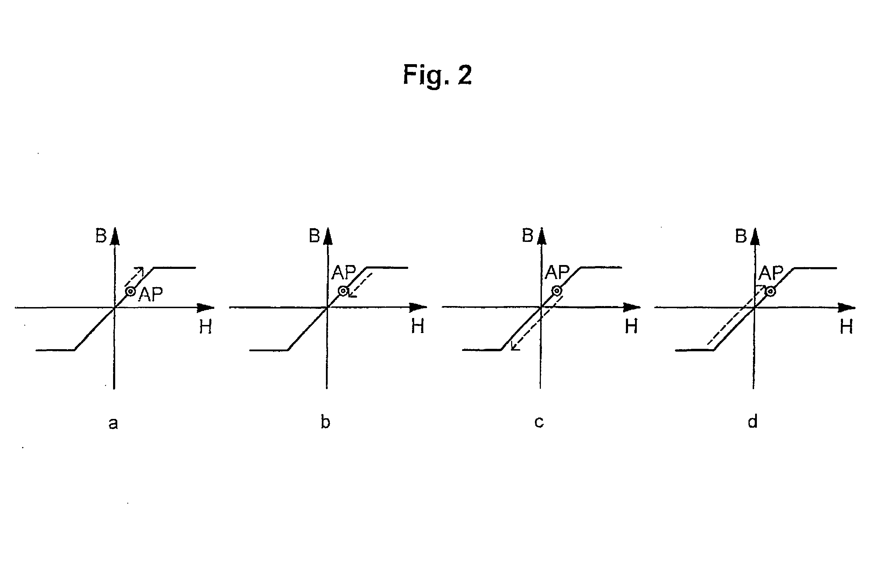

Zur Veranschaulichung der Funktionsweise der Relaxationsschwinger-Schaltung 6 ist in **Fig. 2** ein Durchfahren der Magnetisierungskurve dargestellt. Die nichtlineare Magnetisierungskurve ist dabei so ausgelegt, dass durch einen zunehmenden Strom in einem der Sekundärstromkreise 14a, 14b der weichmagnetische Stromwandlerkern 10 in den Sättigungszustand gebracht werden kann. Wie in **Fig. 2a** dargestellt, wird ausgehend von einem durch den Differenzstrom ΔI vorgegebenen Arbeitspunkt AP die Magnetisierungskurve zunächst durch einen zunehmenden Strom in einem der Sekundärstromkreise in Richtung des positiven Sättigungszustands durchlaufen, wobei die Mitkopplung bewirkt, dass jeweils nur einer der beiden Sekundärstromkreise 14a, 14b den überwiegenden Teil des Stromflusses trägt und der jeweils andere nahezu gesperrt ist. Der Arbeitspunkt AP ist dabei nur durch den primärseitig fließenden Differenzstrom ΔI bestimmt, da sich in diesem Zustand die durch die Sekundärströme hervorgerufenen magnetischen Flüsse aufheben. Das Durchfahren der Magnetisierungskurve wird durch den Stromfluss in den Sekundärstromkreisen 14a, 14b bewirkt. Ist der positive Sättigungszustand erreicht, erfolgt durch die Mitkopplungsschaltung ein gesteuertes Kippen der Sekundärströme derart, dass der zunehmende Sekundärstrom in einen abnehmenden Strom übergeht während der Strom in dem jeweils anderen Sekundärstromkreis 14a, 14b nun zunimmt und die Magnetisierungskurve von dem positiven Sättigungszustand wieder in Richtung des durch den Differenzstrom ΔI vorgegebenen Arbeitspunktes AP **(****Fig. 2b****)** und darüber hinaus bis in den negativen Sättigungszustand durchfahren wird. **(****Fig. 2c****).** In dem negativen Sättigungszustand erfolgt ein erneutes Umkippen der Ströme in umgekehrter Richtung **(****Fig. 2d****).** Das Kippen von einem zunehmenden/abnehmendem Sekundärstrom in einen abnehmenden/zunehmenden Sekundärstrom entspricht einem Vorzeichenwechsel des differenzierten Sekundärstroms, wobei die Dauer eines zunehmenden/abnehmenden Sekundärstroms (Stromflusszeit) abhängig ist von der Lage des Arbeitspunktes AP auf der Magnetisierungskurve. Der Verlauf des Vorzeichenwechsels entspricht den Steuersignalfolgen für die Schalter S1 und S2. Diese komplementären Signalfolgen der Schalter S1 und S2 stellen somit ein zeitmoduliertes Oszillatorsignal dar, das die magnetischen Zustandswechsel zeitlich abgebildet.

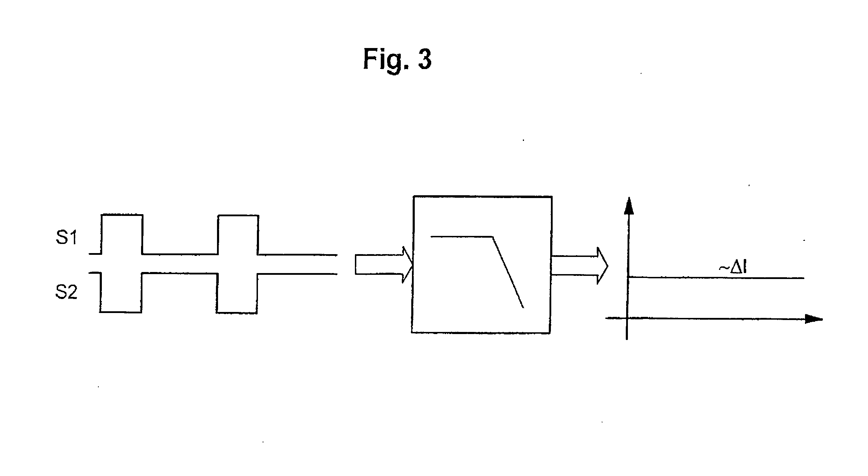

**Fig. 3** zeigt schematisch ein aus der Magnetisierungskurve nach **Fig. 2** abgeleitetes Oszillatorsignal, das sich aus den zwei Signalfolgen der Schalter S1, S2 zusammensetzt und einer nachfolgenden Tiefpassfilterung unterzogen wird. In Abhängigkeit der durch den Differenzstrom ΔI bestimmten Lage des Arbeitspunktes AP ergeben sich unterschiedlich lange High-/Low-Phasen des modulierten Oszillatorsignals, die zu einem differenzstromproportionalen Gleichanteil führen, der in der nachfolgenden Tiefpassfilterung bestimmt werden kann. Dabei werden die Signalfolgen der Schalter S1, S2 parallel ausgewertet, um eine Verdopplung der Empfindlichkeit zu erzielen.

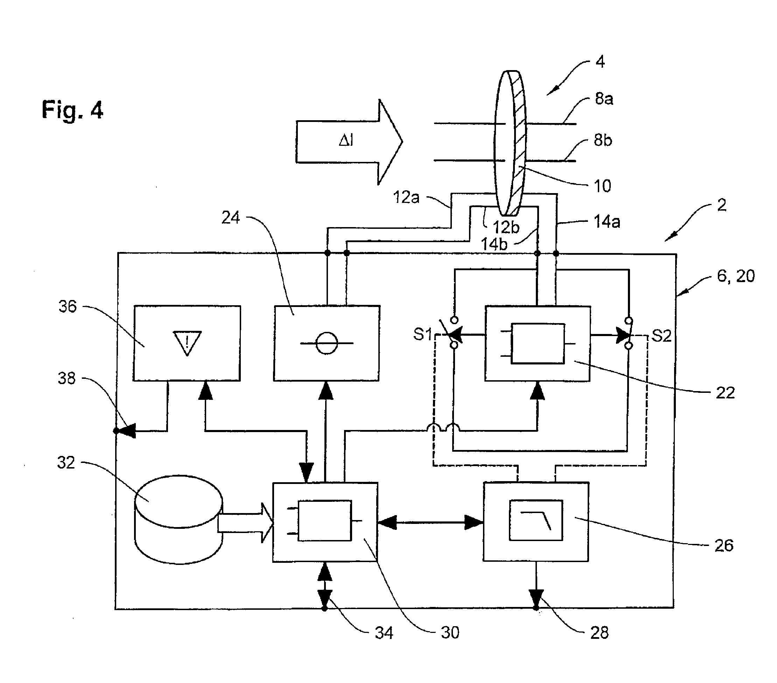

In **Fig. 4** ist ein funktionales Blockschaltbild der Messvorrichtung 2 mit einer als integriertem Schaltkreis 20 ausgeführten Relaxationsschwinger-Schaltung 6 dargestellt. Der integrierte Schaltkreis 20 umfasst eine der Steuerelektronik 18 in **Fig. 1** entsprechendem gesteuerten Oszillator 22 mit zwei Schaltelementen S1, S2 zur Steuerung der Oszillation und eine der Spannungsquelle 16 entsprechende gesteuerte Versorgung 24 der Sekundärstromkreise 14a, 14b. Der integrierte Schaltkreis 20 verarbeitet sowohl analoge Signale in den Funktionsblöcken gesteuerter Oszillator 22 und gesteuerte Versorgung 24, als auch digitale Signale in den nachfolgend beschriebenen Funktionsblöcken.

In einer digitalen Auswerteschaltung 26 wird aus dem modulierten, durch die komplementären Signalfolgen der Schalter S1 und S2 gebildeten Oszillatorsignal nach A/D-Umsetzung mit digitalen Signalverarbeitungsverfahren ein dem Differenzstrom ΔI proportionales Signal gewonnen, welches als analog umgesetztes Ausgangssignal an einem AnalogAusgang 28 der Auswerteschaltung 26 bereitgestellt wird. Die digitale Auswerteschaltung 26 beruht auf einer Verschaltung von präzisen Komparatoren, schnellen digitalen Zählern mit großem Dynamikbereich sowie einem schnellen, dividierenden Rechenwerk und realisiert eine digitale Mittelwertbildung.

Weiterhin umfasst der integrierte Schaltkreis 20 eine Kontroll- und Steuereinheit 30, die bestimmte Parameter der gesteuerten Versorgungseinheit 24 und des gesteuerten Oszillators 22 auf der Basis eines hinterlegten Messstromwandlermodells 32 überwacht und gegebenenfalls korrigiert. Die in dem Messstromwandlermodell 32 gespeicherten Daten können beispielsweise die Übertragungsfunktion des Messstromwandlers 4 beschreiben oder ein T-Ersatzschaltbild des Messstromwandlers 4 sein.

Die Kontroll- und Steuereinheit 30 weist eine digitale Schnittstelle 34 zur Kommunikation in Verbindung mit einem Schnittstellenprotokoll auf. Über diese Schnittstelle 34 kann das differenzstromproportionale Ausgangssignal als digitales Signal ausgegeben werden.

Eine in den integrierten Schaltkreis 20 aufgenommene Diagnoseeinheit 36 zum Testen und Überwachen der Funktion der Relaxationsschwinger-Schaltung 6 erhöht die Zuverlässigkeit der Messvorrichtung 2 und erlaubt den Einsatz auch für sicherheitskritische Anwendungen. Unterstützt werden derartige Einsatzmöglichkeiten durch einen Alarmsignalausgang 38.

## Patentansprüche

1. Verfahren zur galvanisch getrennten, allstromsensitiven Messung eines Differenzstromes (ΔI), mit einer Oszillatorschaltung, die ein magnetfeldempfindliches Bauelement aufweist, das im Verlauf der Oszillation zwischen mindestens zwei Zuständen wechselt, wobei durch den Differenzstrom (ΔI) ein Magnetfeld im Wirkungsbereich des magnetfeldempfindlichen Bauelementes ausgebildet wird und die Oszillatorschaltung ein Oszillatorsignal erzeugt, das zwischen einem Zustand 1 und einem Zustand 2 kippt,
**dadurch gekennzeichnet,**
**dass** in Abhängigkeit des differenzstromgetriebenen Magnetfeldes sich in den Zuständen 1 und 2 einstellende Verweilzeiten des Oszillatorsignals bestimmt werden und aus dem Verhältnis dieser Verweilzeiten ein differenzstromproportionales Ausgangssignal gewonnen wird.

2. Verfahren nach Anspruch 1,
**dadurch gekennzeichnet,**
**dass** die Bestimmung der Verweilzeiten mit einem aus einer Oszillatorfrequenz abgeleiteten Zähltakt erfolgt, dessen Taktrate um ein Vielfaches höher ist als die Oszillatorfrequenz.

3. Verfahren nach Anspruch 1 oder 2,
**dadurch gekennzeichnet,**
**dass** die Erzeugung des Oszillatorsignals sowie die Bestimmung der Verweilzeiten und die Gewinnung des differenzstromproportionalen Ausgangssignals auf digitaler Ebene mit Methoden der digitalen Signalverarbeitung in einem integrierten Schaltkreis (20) erfolgen.

4. Verfahren nach einem der Ansprüche 1 bis 3,
**dadurch gekennzeichnet,**
**dass** das differenzstromproportionale Ausgangssignal als analoges Signal ausgegeben wird.

5. Verfahren nach einem der Ansprüche 1 bis 4,
**dadurch gekennzeichnet,**
**dass** das differenzstromproportionale Ausgangssignal zusätzlich als digitales Signal über eine digitale Schnittstelle (34) ausgegeben wird.

6. Verfahren nach Anspruche 3,
**dadurch gekennzeichnet,**
**dass** der integrierte Schaltkreis (20) analoge und digitale Signale verarbeitet.

7. Verfahren nach einem der Ansprüche 3 bis 6,
**dadurch gekennzeichnet,**
**dass** die Oszillatorschaltung durch eine Kontroll- und Steuereinheit (30) gesteuert wird.

8. Verfahren nach Anspruch 7,
**dadurch gekennzeichnet,**
**dass** die Steuerung der Oszillatorschaltung durch die Kontroll- und Steuereinheit (30) auf einem Modell (32) des verwendeten magnetfeldempfindlichen Bauelementes beruht.

9. Verfahren nach einem der Ansprüche 3 bis 8,
**dadurch gekennzeichnet,**
**dass** mittels einer Diagnoseeinheit (36) ein Test und eine Überwachung der Funktion der Oszillatorschaltung durchführbar sind.

10. Verfahren nach einem der Ansprüche 3 bis 9,
**gekennzeichnet durch**
eine Implementierung als anwendungsspezifischer integrierter Schaltkreis.

11. Vorrichtung zur galvanisch getrennten, allstromsensitiven Messung eines Differenzstromes (ΔI), mit einer Oszillatorschaltung, die ein magnetfeldempfindliches Bauelement aufweist, das im Verlauf der Oszillation zwischen mindestens zwei Zuständen wechselt, wobei durch den Differenzstrom (ΔI) ein Magnetfeld im Wirkungsbereich des magnetfeldempfindlichen Bauelementes ausgebildet wird und die Oszillatorschaltung ein Oszillatorsignal erzeugt, das zwischen einem Zustand 1 und einem Zustand 2 kippt,
**gekennzeichnet durch**
eine Auswerteschaltung zur Bestimmung von in Abhängigkeit des differenzstromgetriebenen Magnetfeldes sich in den Zuständen 1 und 2 einstellenden Verweilzeiten des Oszillatorsignals und zur Gewinnung des differenzstromproportionalen Ausgangssignals aus dem Verhältnis dieser Verweilzeiten.

12. Vorrichtung nach Anspruch 11,
**dadurch gekennzeichnet,**
**dass** zur Bestimmung der Verweilzeiten die Auswerteschaltung eine Zählschaltung zur Erzeugung eines aus einer Oszillatorfrequenz abgeleiteten Zähltaktes aufweist, dessen Taktrate um ein Vielfaches höher ist als die Oszillatorfrequenz.

13. Vorrichtung nach Anspruch 11 oder 12,
**dadurch gekennzeichnet,**
**dass** die Oszillatorschaltung und die Auswerteschaltung als digitale Schaltungen in einem integrierten Schaltkreis (20) ausgeführt sind.

14. Vorrichtung nach einem der Ansprüche 11 bis 13,
**gekennzeichnet durch**
einen Signalausgang (28) für ein analog umgesetztes differenzstromproportionales Ausgangssignal.

15. Vorrichtung nach einem der Ansprüche 11 bis 14,
**gekennzeichnet durch**
eine digitale Schnittstelle (34) zur redundanten Ausgabe eines digitalen differenzstromproportionalen Ausgangssignals.

16. Vorrichtung nach Anspruch 13,
**dadurch gekennzeichnet,**
**dass** der integrierte Schaltkreis (20) Schaltungselemente zur Verarbeitung analoger und digitaler Signale aufweist.

17. Vorrichtung nach Anspruch 13,
**dadurch gekennzeichnet,**
**dass** der integrierte Schaltkreis (20) eine Kontroll- und Steuereinheit (30) zur Steuerung der Oszillatorschaltung aufweist.

18. Vorrichtung nach Anspruch 17,
**dadurch gekennzeichnet,**
**dass** der integrierte Schaltkreis (20) Speichermittel zur Hinterlegung eines Modells (32) des verwendeten magnetfeldempfindlichen Bauelementes aufweist.

19. Vorrichtung nach Anspruch 13,
**dadurch gekennzeichnet,**
**dass** der integrierte Schaltkreis (20) eine Diagnoseeinheit (36) zum Testen und Überwachen der Funktion der Oszillatorschaltung aufweist.

20. Vorrichtung nach Anspruch 13,
**dadurch gekennzeichnet,**
**dass** der integrierte Schaltkreis (20) als anwendungsspezifischer integrierter Schaltkreis ausgeführt ist.

## Claims

1. A method for a galvanically isolated AC/DC-sensitive measurement of a residual current (ΔI), including an oscillator circuit that has a component sensitive to magnetic fields which switches between at least two states in the course of the oscillation, a magnetic field being formed in the sphere of action of the component sensitive to magnetic fields due to the residual current (ΔI) and the oscillator circuit generating an oscillator signal that switches between a state 1 and a state 2,
**characterized in that**
times of stay of the oscillator signal that occur in states 1 and 2 are determined as a function of the residual current-driven magnetic field, and an output signal proportional to the residual current is obtained from the ratio of said times of stay.

2. The method according to claim 1,
**characterized in that**
the times of stay are determined by means of a counting pulse that is derived from an oscillator frequency and whose clock rate is many times higher than the oscillator frequency.

3. The method according to claim 1 or 2,
**characterized in that**
the oscillator signal is generated and the times of stay are determined and the output signal proportional to the residual current is obtained on a digital level by means of methods of digital signal processing in an integrated circuit (20).

4. The method according to any one of claims 1 to 3,
**characterized in that**
the output signal proportional to the residual current is output as an analog signal.

5. The method according to any one of claims 1 to 4,
**characterized in that**
the output signal proportional to the residual current is additionally output as a digital signal via a digital interface (34).

6. The method according to claim 3,
**characterized in that**
the integrated circuit (20) processes analog and digital signals.

7. The method according to any one of claims 3 to 6,
**characterized in that**
the oscillator circuit is controlled by a monitoring and control unit (30).

8. The method according to claim 7,
**characterized in that**
the control of the oscillator circuit by the monitoring and control unit (30) is based on a model (32) of the used component sensitive to magnetic fields.

9. The method according to any one of claims 3 to 8,
**characterized in that**
testing and monitoring of the function of the oscillator circuit can be performed by means of a diagnostic unit (36).

10. The method according to any one of claims 3 to 9,
**characterized by**
an implementation as an application-specific integrated circuit.

11. A device for a galvanically isolated AC/DC-sensitive measurement of a residual current (ΔI), including an oscillator circuit that has a component sensitive to magnetic fields which switches between at least two states in the course of the oscillation, a magnetic field being formed in the sphere of action of the component sensitive to magnetic fields due to the residual current (ΔI), and the oscillator circuit generating an oscillator signal that switches between a state 1 and a state 2,
**characterized by**
an evaluation circuit for determining times of stay of the oscillator signal occurring in states 1 and 2 as a function of the residual current-driven magnetic field and for obtaining the output signal proportional to the residual current from the ratio of said times of stay.

12. The device according to claim 11,
**characterized in that**
for determining the times of stay, the evaluation circuit further comprises a counting circuit for generating a counting pulse that is derived from the oscillator frequency and whose clock rate is many times higher than the oscillator frequency.

13. The device according to claim 11 or 12,
**characterized in that**
the oscillator circuit and the evaluation circuit are configured as digital circuits in an integrated circuit (20).

14. The device according to any one of claims claim 11 to 13,
**characterized by**
a signal output (28) for an output signal proportional to the residual current and converted to analog.

15. The device according to any one of claims 11 to 14,
**characterized by**
a digital interface (34) for the redundant output of a digital output signal proportional to the residual current.

16. The device according to claim 13,
**characterized in that**
the integrated circuit (20) comprises circuit elements for processing analog and digital signals.

17. The device according to claim 13,
**characterized in that**
the integrated circuit (20) comprises a monitoring and control unit (30) for controlling the oscillator circuit.

18. The device according to claim 17,
**characterized in that**
the integrated circuit (20) comprises storage means for storing a model (32) of the used component sensitive to magnetic fields.

19. The device according to claim 13,
**characterized in that**
the integrated circuit (20) comprises a diagnostic unit (36) for testing and monitoring the function of the oscillator circuit.

20. The device according to claim 13,
**characterized in that**
the integrated circuit (20) is implemented as an application-specific integrated circuit.

## Revendications

1. Procédé de mesure isolée galvaniquement sensible à tous les courants d'un courant différentiel (ΔI), comprenant un circuit oscillateur qui a un composant sensible aux champs magnétiques qui alterne entre au moins deux états au cours de l'oscillation, un champ magnétique étant formé dans la zone d'action du composant sensible aux champs magnétiques par le courant différentiel (ΔI) et le circuit oscillateur générant un signal d'oscillateur qui bascule entre un état 1 et un état 2,
**caractérisé en ce que**
des temps de séjour du signal d'oscillateur s'établissant dans les états 1 et 2 sont déterminés en fonction du champ magnétique entraîné par le courant différentiel et un signal de sortie proportionnel au courant différentiel est obtenu à partir du rapport de ces temps de séjour.

2. Procédé selon la revendication 1,
**caractérisé en ce que**
les temps de séjour sont déterminés à l'aide d'une cadence de comptage qui est dérivée d'une fréquence d'oscillateur et dont le taux de cadence est beaucoup plus élevé que la fréquence d'oscillateur.

3. Procédé selon la revendication 1 ou 2,
**caractérisé en ce que**
la génération du signal d'oscillateur et la détermination des temps de séjour et l'obtention du signal de sortie proportionnel au courant différentiel ont lieu au niveau numérique par des méthodes du traitement numérique du signal dans un circuit intégré (20).

4. Procédé selon l'une quelconque des revendications 1 à 3,
**caractérisé en ce que**
le signal de sortie proportionnel au courant différentiel est fourni en sortie comme signal analogique.

5. Procédé selon l'une quelconque des revendications 1 à 4,
**caractérisé en ce que**
le signal de sortie proportionnel au courant différentiel est fourni en sortie de plus comme signal numérique par l'intermédiaire d'une interface numérique (34).

6. Procédé selon la revendication 3,
**caractérisé en ce que**
le circuit intégré (20) traite des signaux analogiques et numériques.

7. Procédé selon l'une quelconque des revendications 3 à 6,
**caractérisé en ce que**
le circuit oscillateur est commandé par une unité de contrôle et commande (30).

8. Procédé selon la revendication 7,
**caractérisé en ce que**
la commande du circuit oscillateur par l'unité de contrôle et commande (30) repose sur un modèle (32) du composant sensible aux champs magnétiques utilisé.

9. Procédé selon l'une quelconque des revendications 3 à 8,
**caractérisé en ce qu'**
un test et une surveillance de la fonction du circuit oscillateur peuvent être effectués au moyen d'une unité de diagnostic (36).

10. Procédé selon l'une quelconque des revendications 3 à 9,
**caractérisé par**
une implémentation comme circuit intégré à application spécifique.

11. Dispositif de mesure isolée galvaniquement sensible à tous les courants d'un courant différentiel (ΔI), comprenant un circuit oscillateur qui a un composant sensible aux champs magnétiques qui alterne entre au moins deux états au cours de l'oscillation, un champ magnétique étant formé dans la zone d'action du composant sensible aux champs magnétiques par le courant différentiel (ΔI) et le circuit oscillateur générant un signal d'oscillateur qui bascule entre un état 1 et un état 2,
**caractérisé par**
un circuit d'évaluation destiné à déterminer des temps de séjour du signal d'oscillateur s'établissant dans les états 1 et 2 en fonction du champs magnétique entraîné par le courant différentiel et à obtenir le signal de sortie proportionnel au courant différentiel à partir du rapport de ces temps de séjour.

12. Dispositif selon la revendication 11,
**caractérisé en ce que**
pour la détermination des temps de séjour, le circuit d'évaluation comprend un circuit de comptage destiné à générer une cadence de comptage qui est dérivée d'une fréquence d'oscillateur et dont le taux de cadence est plus beaucoup élevé que la fréquence d'oscillateur.

13. Dispositif selon la revendication 11 ou 12,
**caractérisé en ce que**
le circuit oscillateur et le circuit d'évaluation sont réalisés comme circuits numériques dans un circuit intégré (20).

14. Dispositif selon l'une quelconque des revendications 11 à 13,
**caractérisé par**
une sortie de signal (28) pour un signal de sortie proportionnel au courant différentiel converti analogiquement.

15. Dispositif selon l'une quelconque des revendications 11 à 14,
**caractérisé par**
une interface numérique (34) destinée à fournir en sortie de manière redondante un signal de sortie numérique proportionnel au courant différentiel.

16. Dispositif selon la revendication 13,
**caractérisé en ce que**
le circuit intégré (20) comprend dés éléments de circuit destinés à traiter des signaux analogiques et numériques.

17. Dispositif selon la revendication 13,
**caractérisé en ce que**
le circuit intégré (20) comprend une unité de contrôle et commande (30) destinée à commander le circuit oscillateur.

18. Dispositif selon la revendication 17,
**caractérisé en ce que**
le circuit intégré (20) comprend des moyens de stockage pour enregistrer un modèle (32) du composant sensible aux champs magnétiques utilisé.

19. Dispositif selon la revendication 13,
**caractérisé en ce que**
le circuit intégré (20) comprend une unité de diagnostic (36) destinée à tester et surveiller la fonction du circuit oscillateur.

20. Dispositif selon la revendication 13,
**caractérisé en ce que**
le circuit intégré (20) est réalisé comme circuit intégré à application spécifique.
